# EUROPEAN PATENT SPECIFICATION

(11) **EP 1 423 716 B1**
(45) Date of publication and mention of the grant of the patent: **28.01.2009**
(21) Application number: 01274432.2
(22) Date of filing: 14.12.2001
(51) Int. Cl.: G01R 29/08

(54) **EMI ANALYZER CAPABLE OF ANALYZING AND REDUCING EACH ELECTROMAGNETIC INTERFERENCE COMPONENT**
EMI-ANALYSIERER MIT DER FÄHIGKEIT ZUR ANALYSE UND REDUKTION JEDER ELEKTROMAGNETISCHEN STÖRUNGSKOMPONENTE
ANALYSEUR D'INTERFERENCES ELECTROMAGNETIQUES PERMETTANT D'ANALYSER ET DE LIMITER CHACUNE DES COMPOSANTES DE CES INTERFERENCES

(30) Priority: 04.08.2001 KR 2001047168
(43) Date of publication of application: 02.06.2004
(73) Proprietor: Emcis Co., Ltd., Anyang-si, 431-715 Gyeonggi-do (KR)
(72) Inventor: KIM, Cheolsoo, Anyang-si, 431-080 Gyeonggi-do (KR)
(74) Representative: Neobard, William John
(86) International application number: PCT/KR2001/002172
(87) International publication number: WO 2003/014749

(56) References cited:
- KR-A- 2001 094 590
- US-A- 4 996 488
- US-A- 6 163 470

## Description

### TECHNICAL FIELD

The present invention relates to an electromagnetic wave measuring apparatus for reducing an electromagnetic interference; and, more particularly, to an electromagnetic interference analyzer capable of either measuring an electromagnetic interference of each line of a power supply in a single measurement or separately measuring two electromagnetic interference noise components.

### BACKGROUND ART

Telecommunications apparatus, Information apparatus, automation apparatus or so on employ a plurality of electric or electronic circuits. If such electric or electronic circuits are closely located with each other, they may be interacted electrically or electronically to be adversely affected with each other. Such adverse electric or electronic interaction is called as an electromagnetic interference. Since the adverse effect becomes larger as the apparatuses are more close to each other, the problem is more critical as the integrity of the electric and electronic circuit increases.

Such problem in designing an apparatus or an electronic circuit is rising as a hot issue. Each electronic apparatus successfully accomplishes the original function without being affected by other apparatuses while it must be designed in order not to adversely affect to the other apparatuses. The electronic apparatus must be well adapted to two conflicting functions, which is called as an electromagnetic compatibility.

There are generally three noise sources which cause noises. First of all, there is an intrinsic noise source which includes thermal noise, shot noise or so on generated due to an intrinsic property of a physical system itself. Secondly, There is a man-made noise which corresponds to a noise generated from man-made apparatus including motors, switches, digital apparatuses, antenna or so on. Thirdly, there is a natural noise which includes a noise generated from thunderbolts or solar spots. Whatever the causes of the noises are, the noises impose a bad effect on the electric or electronic apparatus while it is impossible to absolutely eliminate all noises. It is well known that the best policy is to reduce the noises to the range in which the original function of the apparatuses themselves may not be degraded.

If the electromagnetic noises generated from the electric and electronic apparatus are classified based on a transfer type, there are a conducted emission or noise transmitted through the power supply to the outside and a radiated emission or noise radiated to the air in the type of electromagnetic wave.

A conductor itself, which lies in a noise environment, may be affected by the noise environment and may also be used as a medium to pick up and transmit the noise to other sides. In the meantime, moving electric charge always generates an electromagnetic wave, which is an important noise source to impose a bad effect on other circuit parts.

The generated noises have an adverse impact on the electric or the electronic apparatus, which is called as an electromagnetic interference. Each country sets its own standard for the electromagnetic interference. An international standard for the electromagnetic interference is also provided. A product that does not meet those standards is not allowed to be distributed through normal markets.

In general, it is well known that applicable grounding and shielding techniques may be used to easily reduce the radiated noises in a certain degree. On the other hand, it is far from easy to measure the conductive noises and it is not easy to control the conductive noises so that a lot of time and efforts may be required to reduce the conductive noises in the course of a product development process.

The conductive noises represent a noise that is generated from the electric and electronic apparatus connected to a conventional common power supply and transmitted to outside through the power supply. In order to set up a preferable counter plan for the conductive noises, it is required to exactly measure the conductive noises.

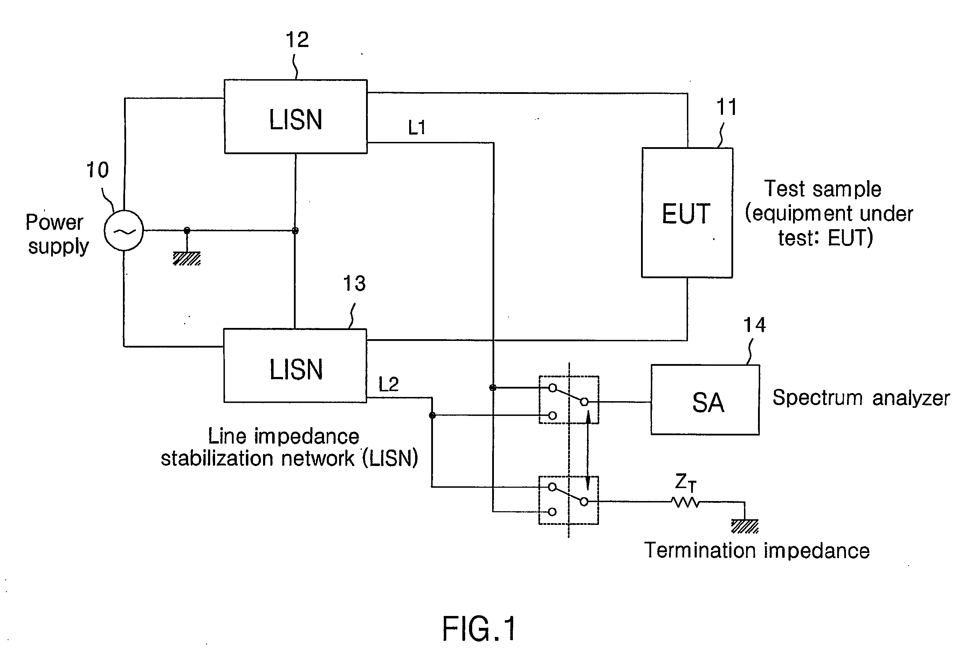

In a conventional method to measure the conductive noise as shown in Fig. 1, line impedance stabilization networks (LISNs) 12 and 13 are inserted between a power supply 10 having a ground and a test sample 11 called as an equipment under test (EUT).

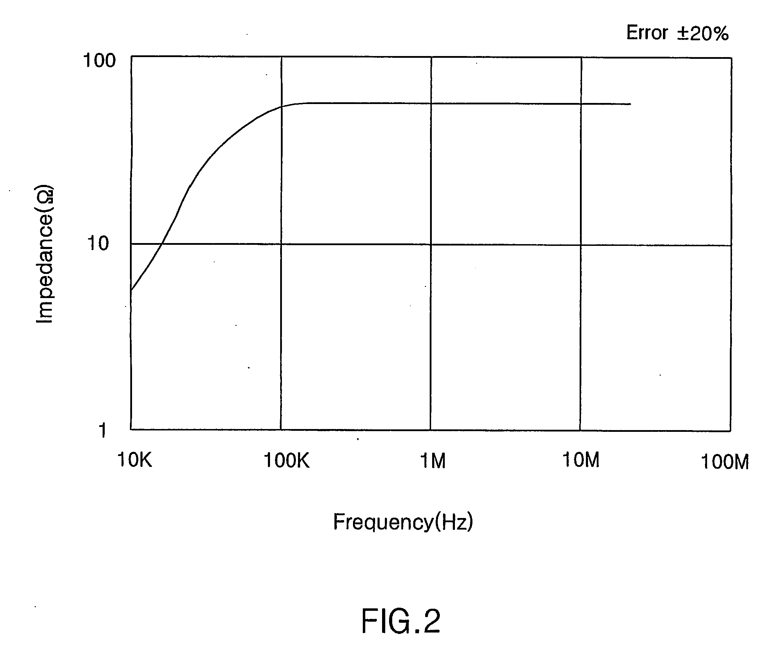

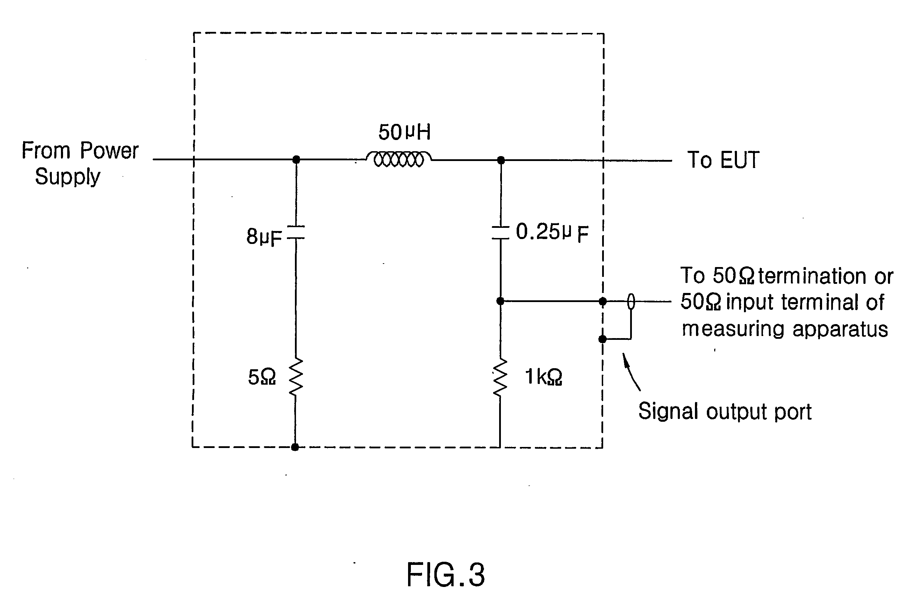

The LISNs represent a circuit having impedance to frequency characteristic as shown in Fig. 2. Referring to Fig. 3, there is illustrated an exemplary circuit having the impedance to frequency characteristic shown in Fig. 2 in a frequency range of 9 kHz to 30 MHz.

The LISNs 12 and 13 prevent the conductive noises generated at the test sample 11 from being transmitted to the power supply 10 and are used to detect the conductive noises.

The conductive noises detected at the LISNs 12 and 13 may be measured by using a conventional electromagnetic interference receiver 14. One detection terminal of the LISNs 12 and 13 not to be used to detect the conductive noises is coupled with equivalent termination impedance Z_{T}.

The conductive noises of each power supply measured as described above include a common mode noise caused by a common mode current component and a differential mode noise caused by a differential mode current component.

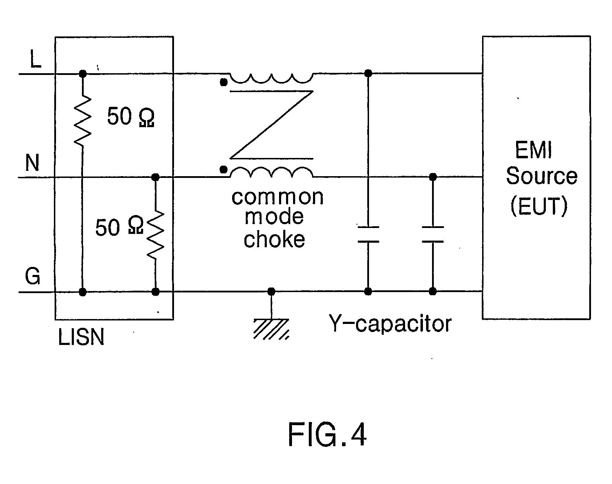

In order to reduce the common mode noise and the differential mode noise, a filter is required between the LISNs and the test sample. Referring to Figs. 4, 5 and 6, there are a series of exemplary filters.

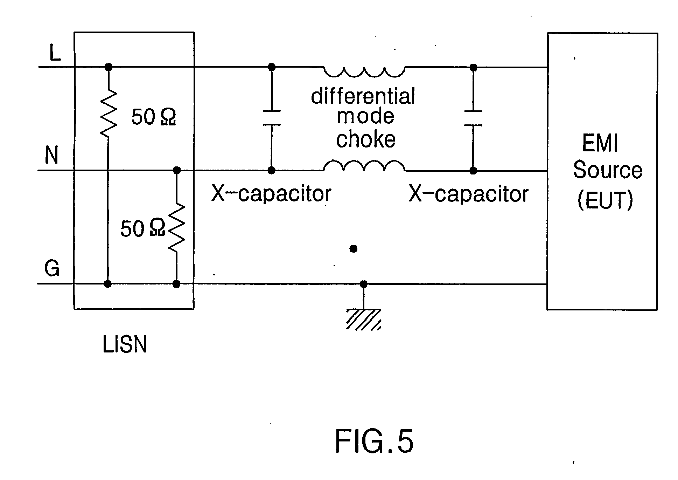

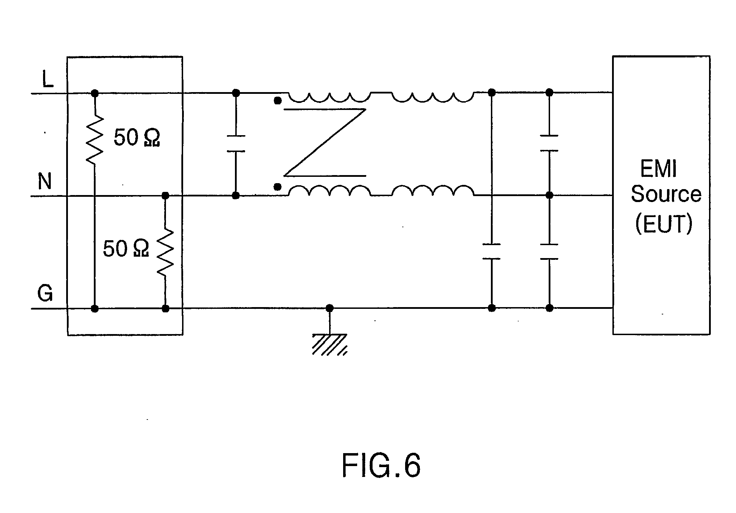

Referring to Fig. 4, there is illustrated an exemplary filter capable of reducing the common mode noise. A coil and a capacitor used in the filter are called as a common choke and a Y capacitor, respectively. Referring to Fig. 5, there is illustrated an exemplary filter capable of reducing the differential mode noise. A coil and a capacitor used in the filter are called as a differential choke or a normal coil and an X capacitor, respectively. Referring to Fig. 6, there is illustrated a composite filter for combined with the filters shown in Figs. 4 and 5.

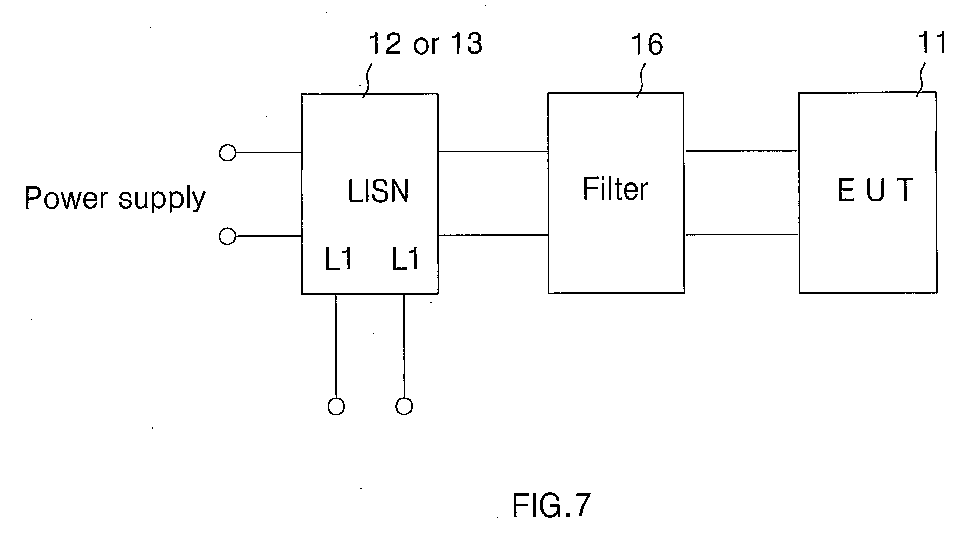

Referring to Fig. 7, there is shown a method for connecting the LISNs 12 and 13, the filter 16 and the test sample 11 according to the configuration diagram of the conventional electromagnetic interference noise measuring system shown in Fig. 1.

As shown in Fig. 7, the filters shown in Figs. 4, 5 and 6 are positioned between the LISNs 12 and 13 and the test sample 11 so that a plurality of filters may be implemented to reduce both the common mode noises and the differential mode noises.

In the method for positioning a conventional noise filter shown in Fig. 7, when the power supply 10 is provided to the LISNs 12 and 13, the electromagnetic noises generated at the normal state in which the test sample 11 is normally operated is transmitted through the filter 16 to be damped and the damped noise is detected by the LISNs 12 and 13. The detected noise is outputted through output terminals L1 and L2. The outputted noise is transferred to the EMI receiver shown in Fig. 1 to be measured.

Since, however, the signal detected at the detection terminals of the LISNs 12 and 13 corresponds to the composite noise of the common mode and the differential mode, it is impossible to distinguish the common mode noise from the differential mode noise.

As a result, it is very difficult to determine how a plurality of components are arranged to manufacture a product with only the measurement result of composite noise. Therefore, a trial and error method that requires a lot of time and efforts is generally used to reduce the conductive noise.

In order to design a damping filter based on the conventional conductive noise measuring method described above, a lot of filters should be applied to the test sample 11 and a series of operations to the conductive noise must be repeated. At the same time, the trial and error method as described above involves a number of cumbersome operations.

In order to use a debugging module in which the conventional damping filters are used for damping the signal directly, the power supply should be turned off, the lid of the test sample 11 should be lifted, a plurality of filters are replaced with other filters, the lid of the test sample 11 should be closed, the power supply should be applied and, then, the signal may be tested to find if the noise signal is damped.

If, however, the damped signal does not fall within a desired level, the series of steps described above must be repeated. Specifically, one or more filters are replaced with new filters and the signal is tested again so that a lot of time may be required.

Since the method for designing a damping filter based on the composite conductive noise of the common mode noise and the differential mode noise requires a lot of time, the time and cost required for developing a product must be increased. Furthermore, it is difficult to establish a product development plan and, moreover, the time and the cost may obstruct a manufacturer to compete with other manufacturers.

US Patent 4,996,488 discloses a selectable mode rejection network (SMRN) for electromagnetic interference (EMI) which prevents common mode (CM) and, alternatively, differential mode (DM) conducted emissions (CE) from entering power transmission lines form electrical equipment powered from such lines and producing such unwanted electrical noise. Phase-switching the SMRN determines whether CM or DM is so excluded, thereby facilitating measurement of the unexcluded type of CE. So used in measuring EMI, such SMRN enables improved filter design for the respective types of CE and composite filters for limiting both CM and DM CE.

It is, therefore, an object of the present invention to provide an electromagnetic interference analyzer for separately measuring both the common mode noise and the differential mode noise which correspond to two components of the conductive noise detected through the line impedance stabilization network.

It is another object of the present invention to provide a power line noise measuring and reducing system for measuring the conductive noise transmitted through the power line for each mode so as to solve more easily and rapidly an electromagnetic interference problem by using a damping filter design.

In its broadest aspect the invention provides an apparatus in accordance with claim 1.

### BRIEF DESCRIPTION OF DRAWINGS

The above and other objects and features of the present invention will become apparent from the following description of preferred embodiments given in conjunction with the accompanying drawings, in which:
Fig. 1 shows a schematic diagram of a conventional conductive noise measuring apparatus;
Fig. 2 represents a diagram for illustrating characteristic relations between impedance and frequency of a conventional line impedance stabilization network;
Fig. 3 describes an exemplary circuit of the line impedance stabilization network for representing the characteristic relations shown in Fig. 2;
Fig. 4 provides an exemplary filter for reducing a common mode noise;
Fig. 5 presents an exemplary filter for reducing a differential mode noise;
Fig. 6 depicts an exemplary composite filter, in which two filters shown in Figs. 4 and 5 are combined, for reducing a noise;
Fig. 7 illustrates a configuration diagram with filters of Figs. 4 to 6 located between the line impedance stabilization network and the test sample;
Fig. 8 describes a configuration diagram of an apparatus for measuring an electromagnetic interference noise in accordance with the present invention;
Fig. 9 provides an external configuration of an electromagnetic interference receiver in accordance with the present invention;
Fig. 10 represents an interior configuration of an electromagnetic interference receiver in accordance with the present invention;
Fig. 11 presents an operation illustration for representing a connection state of each switch in an L1 measuring mode of the electromagnetic interference receiver shown in Fig. 10;
Fig. 12 is an operation illustration, for representing a connection state of each switch in an L2 measuring mode of the electromagnetic interference receiver shown in Fig. 10;
Fig. 13 represents an operation illustration for representing a connection state of each switch in a common measuring mode and a differential measuring mode of the electromagnetic interference receiver shown in Fig. 10;
Fig. 14 shows the interior configuration of the CM/DM selection module; and
Figs. 15A and 15B illustrate the common mode and the differential mode, respectively.

### BEST MODE FOR CARRYING OUT THE INVENTION

From now on, referring to the attached drawings, a plurality of embodiments will be specifically described in accordance with the technical subject of the present invention.

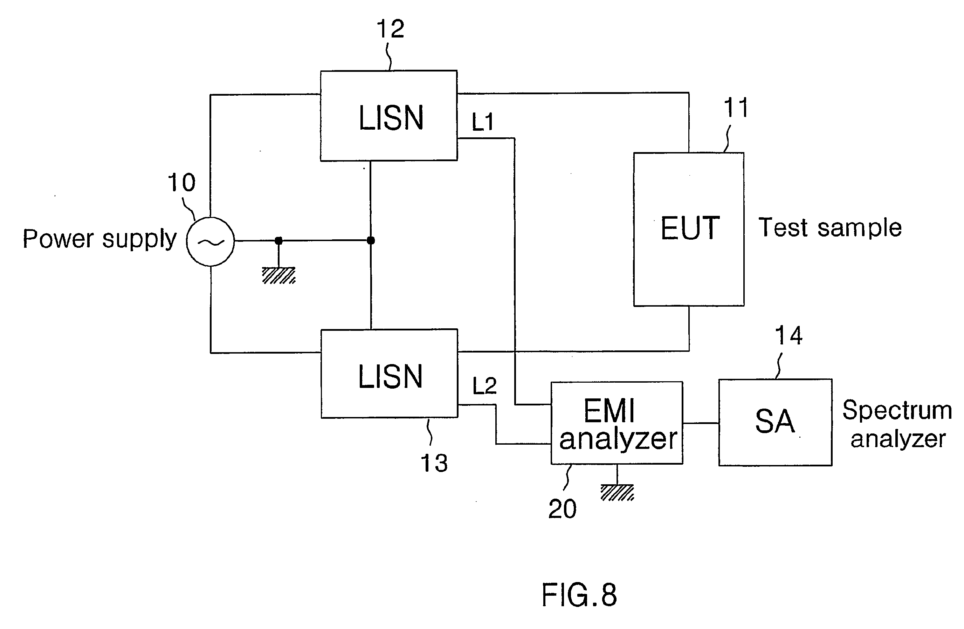

Referring to Fig. 8, there is shown a first embodiment in accordance with the present invention. Noises generated from a test sample 11 are detected by two line impedance stabilization networks (LISNs) 12 and 13 as detected noise signals, which are transmitted to an EMI analyzer as an input signal in accordance with the present invention.

After receiving the input signal, the EMI analyzer selects a noise signal corresponding to a selected mode and transmits the selected noise signal to the EMI receiver 14 in order to measure the select noise signal.

The EMI analyzer 20 functions as a medium for receiving the signals detected through the LISNs 12 and 13 and transmitting the noise signal corresponding to the selected mode to the EMI receiver 14.

The EMI analyzing device 20 operates largely in two separate modes.

In a first mode, the EMI analyzer 20 receives the signals detected through two LISNs 12 and 13 and bypasses each of two signals L1 and L2 as an output. Specifically, a user may select either a mode for detecting a signal L1 or another mode for detecting another signal L2.

In a second mode, the received signals may be separately outputted as either a common mode or a differential mode. In the second mode, a mode for detecting a separated common mode noise and the other mode for detecting a separated differential mode noise may be divided.

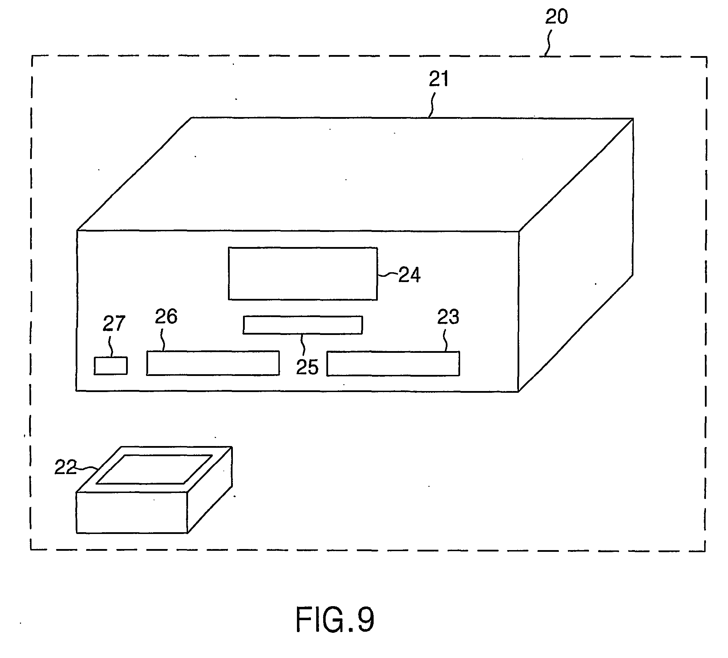

Referring to Fig. 9, there is illustrated an external configuration of the EMI analyzer 20 shown in Fig. 8 in accordance with the present invention. The EMI analyzer 20 is generally composed of a main body 21 and a debugging module 22.

In the front of the body 21, there are installed an input selection means 23 for connecting the signals L1 and L2 detected at and transmitted from the LISNs 12 and 13 with the output signal of the EMI analyzer, a display means 24 for displaying a selection mode in order to indicate which mode is selected, a selection switching means 25 capable of selecting a mode to be measured, a debugging module connection means 26 for connecting the body 21 with the debugging of module 22, a power switch 27 or so on. For user's convenience, these means may be installed on other parts of the body 21 which are not shown on the drawings.

Although the test sample 11 is being operated, a previously manufactured standard filter of the debugging module 22 separated from the body is used to immediately damp the signals L1 and L2 detected through LISNs 12 and 13.

In order to overcome the drawbacks of the conventional debugging module described above, the filter may be directly installed to immediately damp the signals with neither turning off the power supply nor opening the case of the debugging module 22.

If the damped signal is not preferable, the series of operations described above may not be repeated. Only the filter is replaced with another and, then, the signal may be damped. Therefore, it is unnecessary to turn off the power supply or to open the case so that the test time may be considerably reduced.

Such debugging module 22 may be constructed manually so that the user may directly select the standard filter and couple it with the debugging module 22. The debugging module 22 may be constructed automatically so that it may select the filter automatically. The user may select the debugging module 22 either manually or automatically for convenience.

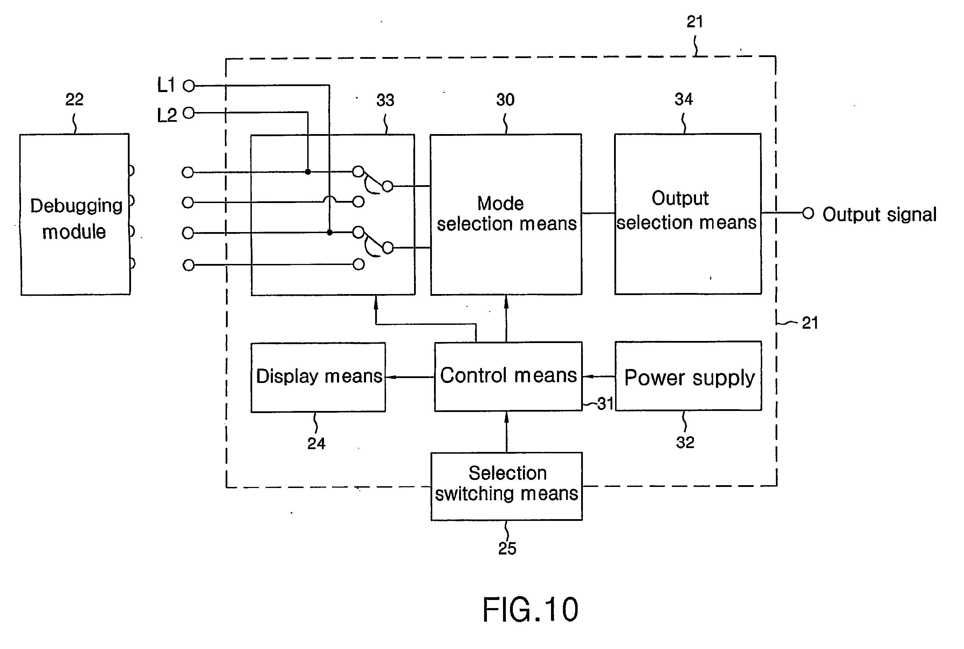

Fig. 10 shows an interior configuration of the body 21 shown in Fig. 9. The body 21 includes a selection switching means 25 which the user operates to select a required mode; a mode selection means 30 for receiving two signals L1 and L2 detected through the LISN 12 and 13 and capable of being operated in order to select one of 4 modes which are an L1 mode for detecting an L1 signal, an L2 mode for detecting an L2 signal, a common mode and a differential mode; the display means 24 for displaying the selected mode; a power supply 32 for providing a supply voltage required to the body 21; an input selection means 33 for selecting an input signal; an output selection means for selecting a mode of an output signal; and a control means 31 for totally controlling each of the means described above.

When the debugging module 22 is not used, the debugging module connection means 26 used to be connected with the input end L1 and L2 may be detached or deleted from the body 21.

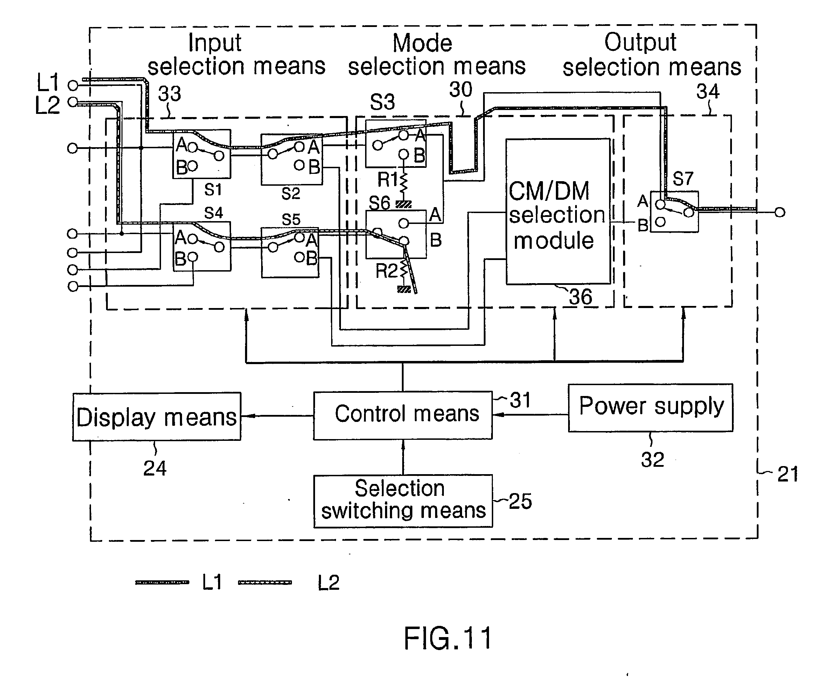

Referring to Figs. 11 to 13, there will be specifically illustrated the operation for each mode of the EMI analyzer 20 as follows.

First of all, a signal may be measured from one line L1 of the power supply. Referring to Fig. 11, there are illustrated the connection method of each switch and the operational concept thereof within the body 21 in this case. If a user selects a detection signal L1 among the detection signals of LISNs 12 and 13 at the selection switching means 25, the control means 31 allows the display means 24 to display that the L1 signal has been selected and transmits the L1 signal to the input selection means 33.

The L1 signal allows the switch S1 in the input selection means 33 to be connected with a terminal A among the terminals A and B, allows the switch S2 to be connected with a terminal A among the terminals A and B and allows the switch S3 of the mode selection means 30 to be connected with a terminal A among the terminals A and B.

Accordingly, the signal L1 is transmitted to the output selection means 34. If the switch S7 of the output selection means 34 is connected with a terminal A, the output signal is transmitted to the EMI receiver 14, an electromagnetic measuring apparatus or so on to be measured.

In the meantime, the control means 31 allows the signal L2 to be transmitted to the input selection means 33, allows the switch S4 in the input selection means 33 to be connected with a terminal A among the terminals A and B, allows the switch S5 to be connected with a terminal A among the terminals A and B and allows the switch S6 of the mode selection means 30 to be connected with a terminal B among the terminals A and B so as to be connected to a terminal impedance resister R2. In the result, the EMI receiver 14, the electromagnetic wave measuring apparatus or so on may be used to measure the L1 signal, i.e., a total EMI noise of the line L1, i.e., one of two inputs of the power supply.

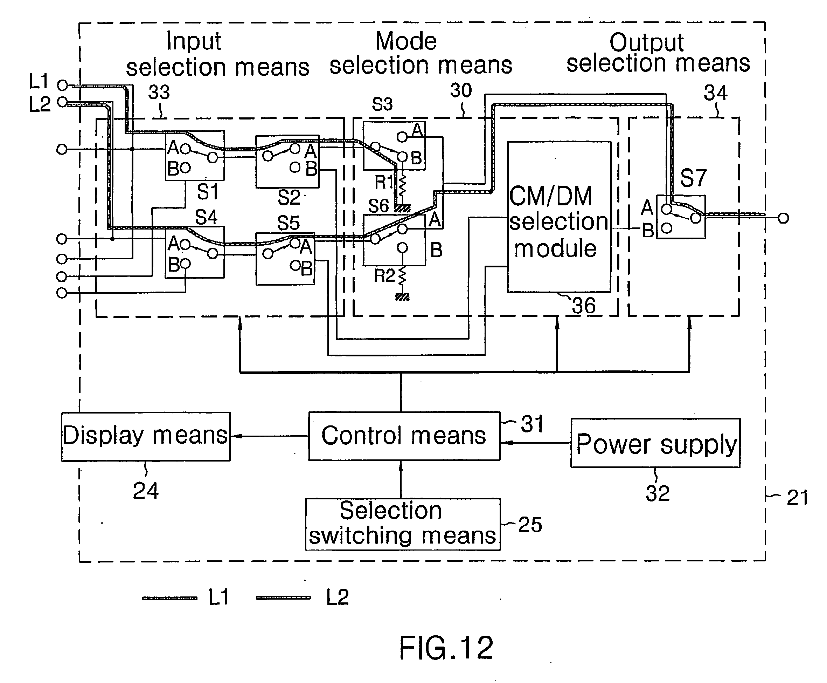

Secondly, another signal may be measured from another line L2 of the power supply. Referring to Fig. 12, there are illustrated the connection method of each switch within the body 21 and the operation concept thereof. If a user selects a detection signal L2 among the detection signals of LISNs 12 and 13 at the selection switching means 25, the control means 31 allows the display means 24 to display that the L2 signal has been selected and transmits the L2 signal to the input selection means 33.

The L2 signal allows the switch S4 in the input selection means 33 to be connected with a terminal A, allows the switch S5 to be connected with a terminal A and allows the switch S6 of the mode selection means 30 to be connected with a terminal A.

Accordingly, the L2 signal is transmitted to the output selection means 34. If the switch S7 of the output selection means 34 is connected with a terminal A, the output signal is transmitted to the EMI receiver 14, a electromagnetic wave measuring apparatus or so on to be measured.

In the meantime, the control means 31 allows the signal L1 to be transmitted to the input selection means 33 so that it may allow the switch S1 in the input selection means 33 to be connected with a terminal A, allows the switch S2 to be connected with a terminal A and allows the switch S3 of the mode selection means 30 to be connected with a terminal B so as to be connected to a terminal impedance resister R1.

In the result, the EMI receiver 14, the electromagnetic wave measuring apparatus or so on may be used to measure the L2 signal, i.e., a total EMI noise of the line L2, i.e., another line of two input of the power supply.

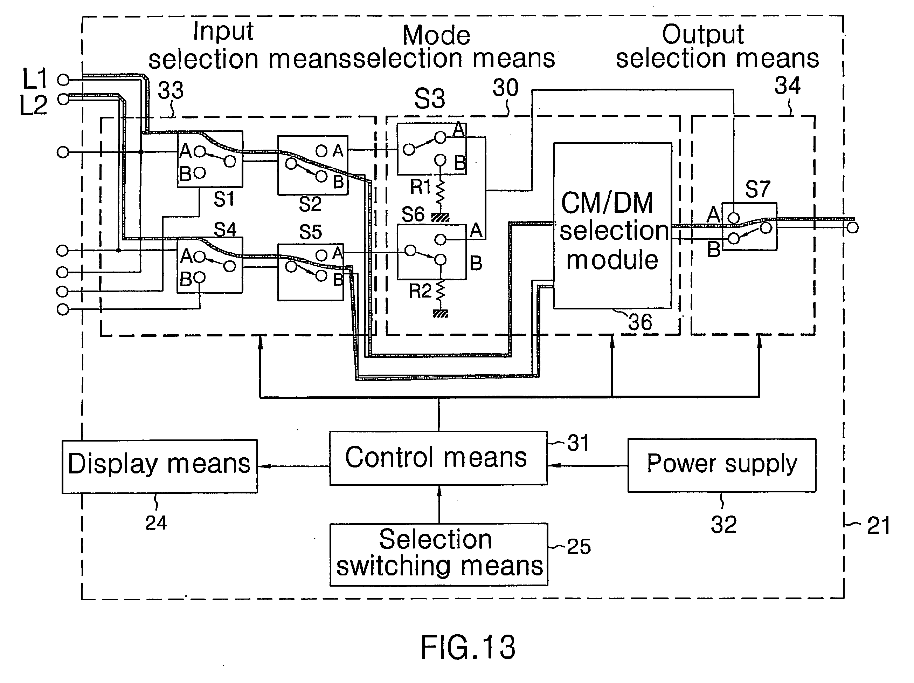

Thirdly, there is illustrated a method for measuring a common mode noise of the power supply and the operation concept thereof. Referring to Fig. 13, there are illustrated the connection method of each switch within the body 21 and the operation concept thereof. If a user selects a common mode CM at the selection switching means 25, the control, means 31 allows the display means 24 to display that the common mode has been selected.

The control means 31 allows both the L1 signal and the L2 signal to be inputted to the input selection means 33 and allows a common mode/differential mode (CM/DM) selection module 36 of the mode selection means 30 to be operated as a CM mode.

The switches S1 and S4 of the input selection means 33 are allowed to be connected with a terminal A and the switches S2 and S5 to be connected with a terminal B. In the result, both the L1 signal and the L2 signal are allowed to be inputted to the CM/DM selection module 36 of the mode selection means 30. The control means 31 generates a signal, which is used to allow the CM/DM selection module 36 to select the CM mode.

The CM/DM selection module 36 of the mode selection means 30 receives the L1 signal and the L2 signal and selectively generates only a noise between the ground and each line between two signals.

The noise component outputted as described above becomes a common mode noise component. If the common mode noise component is inputted to the output selection means 34 and the control signal allows the switch S7 of the output selection means 34 to be connected with a terminal B, the output signal, i.e., the common mode noise is inputted to the EMI receiver 14, the electromagnetic wave measuring apparatus or so on to be measured.

In the result, the EMI receiver 14, the electromagnetic wave measuring apparatus may measure a common mode (CM) signal, i.e., a noise between each input line of the power supply and the ground.

Fourthly, referring to Fig. 13, there is illustrated a method for measuring a differential mode noise of the power supply and the operation thereof. If a user selects a differential mode DM at the selection switching means 25, the control means 31 allows the display means 24 to display that the differential mode has been selected.

The control means 31 allows both the L1 signal and the L2 signal to be inputted to the input selection means 33 and allows the CM/DM selection module 36 of the mode selection means 30 to be operated as a DM mode.

The L1 signal and the L2 signal allow the switches S1 and S4 of the input selection means 33 to be connected with a terminal A and allow the switches S2 and S5 to be connected with a terminal B so that both the L1 signal and the L2 signal may be allowed to be inputted to the CM/DM selection module 36 of the mode selection means 30. The control means 31 generates a signal, which is used to allow the CM/DM selection module 36 to select the DM mode.

The CM/DM selection module 36 of the mode selection means 30 receives the L1 signal and the L2 signal and selectively generates only a noise between two lines between two signals. The noise component outputted as described above becomes a differential mode noise component.

If the differential mode noise component is inputted to the output selection means 34 and the control signal allows the switch S7 of the output selection means 34 to be connected with a terminal B among the terminals A and B, the output signal is allowed to be inputted to the EMI receiver 14, the electromagnetic wave measuring apparatus to be measured.

In the result, the EMI receiver 14, the electromagnetic wave measuring apparatus or so on may be used to measure a differential mode (DM) signal, i.e., a noise between two inputs of the power supply.

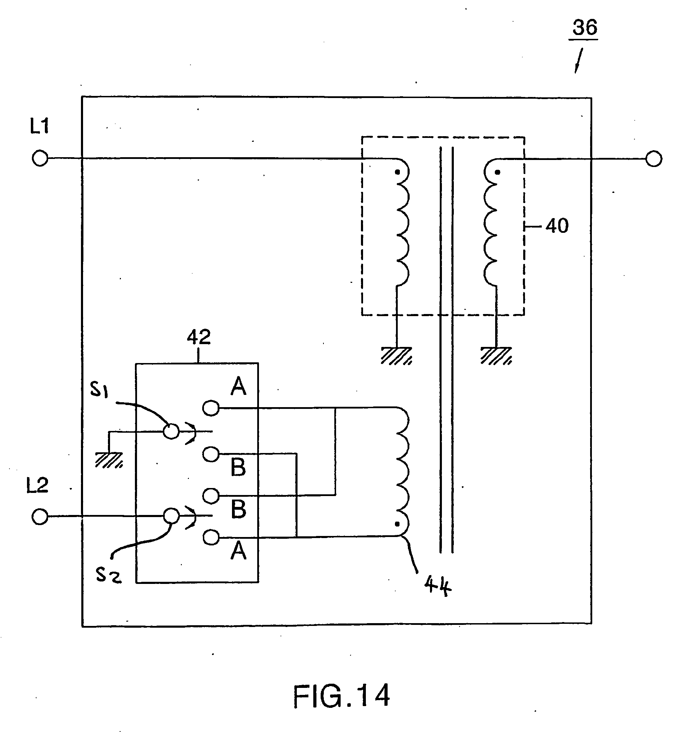

Referring to Fig. 14, the common mode signal and the differential mode signal may be more specifically defined.

Fig. 14 specifically shows the interior configuration of the CM/DM selection module 36, in which the L1 signal and the L2 signal are transmitted as inputs through the input selection means. A line extended from the L1 is connected with a terminal of a line transformer 40 and another terminal of the line transformer 40 is connected with a terminal B of the switch S7 in the output selection means 34. In the meantime, a line extended from the L2 is connected with the switch S2 of a mode selection switch box 42. A terminal of the switch S1 of the mode selection switch box 42 is coupled to the ground. A terminal A of the switch S1 and a terminal B of the switch S2 coupled with each other are connected with a terminal of a selection transformer 44 and a terminal B of the switch S1 and a terminal A of the switch S2 coupled with each other are connected with another terminal of the selection transformer 44. Referring to Fig. 14, the polarity of each transformer 40 and 44 has been shown as a dot.

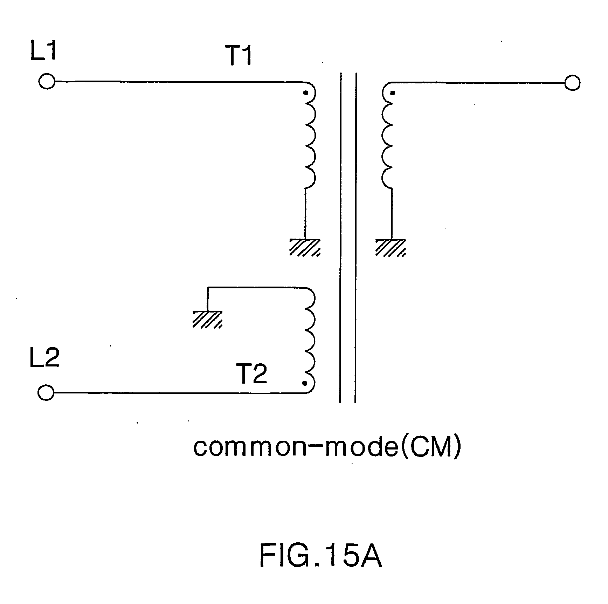

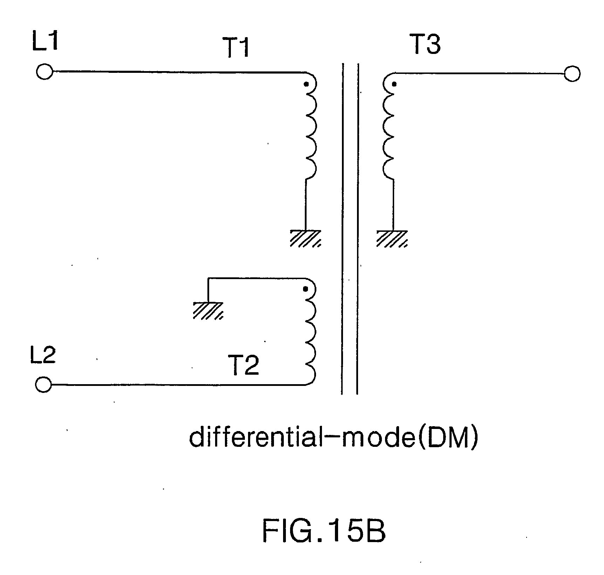

Referring to Figs 14 and 15 in order to illustrate the operation of the CM/DM selection module 36, if all the switches S1 and S2 of the mode selection switch box 42 are connected with a terminal A, the common mode is set as shown in Fig. 15A. In the meantime, if all the switches S1 and S2 of the mode selection switch box 42 are connected with a terminal B, the differential mode is established as shown in Fig. 15B.

From now on, there will be illustrated the debugging module, which has preferable filters, used to be capable of immediately damping the signals detected through the LISNs 12 and 13 while the test sample 11 is operated.

If a user selects the debugging module 22 at the selection switching means 25 in the measuring methods for 4 modes as described above, the control means 31 allows the display means 24 to display that the external debugging module 22 is selected.

The L1 signal and the L2 signal are transmitted to the debugging module 22 as shown in Figs. 11 to 13. The debugging module 22 may include an inductor L and a capacitor C. The values of the inductor L and the capacitor C are used to measure the L1 signal and the L2 signal and a damped value in the common mode and the differential mode is transmitted to the EMI receiver 14, the electromagnetic wave measuring apparatus or so on to be measured.

Accordingly, the filter circuit capable of damping the noise generated at the test sample 11 may be constructed. In other words, a range of frequency band in which the wave value is larger than a threshold value predetermined in the waveforms of the -common mode and the differential mode is firstly calculated. In the common mode, the value of L is previously estimated while, in the differential mode, the value of C is first estimated. Then, the values of the other devices are estimated to construct the filter circuit.

### INDUSTRIAL APPLICABILITY

As described above, the present invention relates to an electromagnetic wave measuring apparatus capable of either measuring an electromagnetic interference of each power supply in a time or separately measuring two components of an electromagnetic interference noise. Only the noise component required based on a use's selection may be provided to the EMI receiver 14 so that the noises generated at the test sample 11 for each mode may be easily analyzed. Accordingly, the counter plan for the electromagnetic interference may be easily and rapidly established.

If the debugging module is installed on the outside of the body, it may be used with the standard filter to damp the signal while the power is applied and, therefore, the required filter may be easily and rapidly determined. Accordingly, a replacement component applied to the noise filter circuit may be rapidly and exactly established without a lot of trials and errors. Since, as a result, the time required to design the noise filter circuit may be considerably reduced and working efficiency may be enhanced to rapidly cope with the product market.

Accordingly, the development plan for electric or the electronic apparatuses may be effectively established so that the product development time may be reduced and the development cost may also be reduced.

While the invention has been shown and described with respect to the preferred embodiments, it will be understood by those skilled in the art that various changes and modifications may be made without departing from the scope of the invention as defined in the following claims.

## Claims

1. An apparatus for analyzing an electromagnetic interference by dividing a conductive noise generated from an equipment under test (EUT) into 4 modes to be measured, wherein the 4 modes include an L1 mode for measuring a noise from one line L1 of power lines, an L2 mode for measuring a noise from the other line L2 of the power lines, a common mode for measuring a noise between the line L1 and/or the line L2 and a ground and a differential mode for measuring a noise between the line L1 and the line L2, the apparatus comprising a selection switch means (25) for selecting a mode among the 4 modes based on a user's selection to generate a selection signal, an input mode selection means for operating a plurality of switches employed therein to be switched as the selected mode based on the selection signal, an output selection means (34) for selecting one of outputs of the input mode selection means; and a control means for controlling the input mode selection means and the output mode selection means based on the selection signal,
wherein the input mode selection means includes:
a switch (S2) for switching inputted L1 signal based on the selection signal;
a switch (S5) for switching inputted L2 signal based on the selection signal; and
a switch (S3), connected with the switch(S2), for selecting the L1 mode by determining whether the L1 signal outputted from the input selection means is to be connected with the output selection means or a terminal impedance connected with a ground, a switch(S6), connected with the switch (S5), for selecting the L2 mode by determining whether the L2 signal outputted from the input selection means is connected with the output selection means or a terminal impedance connected with the ground, and a common mode/differential mode (hereafter, "CM/DM") selection module (36), connected with each of the switch(S2) and the switch (S5), for receiving the L1 signal and the L1 signal outputted from the input selection means and selecting whether either a common mode or a differential mode is to be determined,
wherein the CM/DM selection module (36) contains:
a line transformer (40) for receiving the L1 signal as the input thereto and transmitting an output therefrom to the output selection means;
a mode selection switch box (42) for receiving the L2 as the input thereto, wherein the mode selection switch box has a switch for determining either the common mode or the differential mode; and
a selection transformer (44) for selecting either the common mode or the differential mode by switching over two terminals thereof based on the switch selection of the mode selection switch box (42), wherein a core and a secondary winding thereof are shared with those of the line transformer.

2. The apparatus of claim 1, further comprising a power supply (32) for providing a supply voltage to the selection switch means, the input mode selection means, the output selection means and the control means;

3. The apparatus of claim 1 or 2 wherein the output selection means is connected with an electromagnetic interference receiver (14) for analyzing the signal outputted therefrom

4. The apparatus of claim 1, 2 or 3 further comprising a debugging module (22), which has a standard filter, for damping the signals from the L1 and the L2 by using the standard filter when a test sample is operated to establish a noise counter plan.

## Patentansprüche

1. Vorrichtung zum Analysieren einer elektromagnetischen Störung durch Teilen eines leitenden Rauschens, das von einer Einrichtung, die gerade getestet wird (EUT) generiert wird, in vier zu messende Moden, wobei die vier Moden einen L1-Modus zum Messen eines Rauschens aus einer Leitung L1 von Stromleitungen, einen L2-Modus zum Messen eines Rauschens aus der anderen Leitung L2 der Stromleitungen, einen Gleichtaktmodus zum Messen eines Rauschens zwischen der Leitung L1 und/oder der Leitung L2, und einen Erd- und einen Differentialbetrieb zum Messen eines Rauschens zwischen der Leitung L1 und der Leitung L2 umfassen, wobei die Vorrichtung ein Auswahl-Schaltmittel (25) zum Auswählen eines Modus aus den vier Moden basierend auf einer Auswahl eines Benutzers zum Generieren eines Auswahlsignals, ein Eingabemodus-Auswahlmittel zum Betreiben einer Mehrzahl von Schaltern, die eingesetzt werden, um wie der Auswahlmodus basierend auf dem Auswahlsignal geschaltet zu werden, ein Ausgabe-Auswahlmittel (34) zum Auswählen einer der Ausgaben des Eingabemodus-Auswahlmittels und ein Steuermittel zum Steuern des Eingabemodus-Auswahlmittels und des Ausgabemodus-Auswahlmittels basierend auf dem Auswahlsignal aufweist,
wobei das Eingabemodus-Auswahlmittel enthält:
einen Schalter (S2) zum Schalten eines eingegangen L1-Signals basierend auf dem Auswahlsignal;
einen Schalter (S5) zum Schalten eines eingegangen L2-Signals basierend auf dem Auswahlsignal; und
einen Schalter (S3), der mit dem Schalter (S2) verbunden ist, zum Auswählen des L1-Modus durch Bestimmen, ob das vom Eingabe-Auswahlmittel ausgegebene L1-Signal mit dem Ausgabe-Auswahlmittel oder mit einem mit einer Erdung verbundenen Belastungswiderstand zu verbinden ist, einen mit dem Schalter (S5) verbundenen Schalter (S6) zum Auswählen des L2-Modus durch Bestimmen, ob das vom Eingabe-Auswahlmittel ausgegebene L2-Signal mit dem Ausgabe-Auswahlmittel oder mit einem mit der Erdung verbundenen Belastungswiderstand verbunden ist, und zum Auswählen eines Gleichtaktmodus-Differentialbetrieb-Auswahlmoduls (36) (ersteres ist im Folgenden mit "CM/DM" bezeichnet), das mit jedem der Schalter (S2) und (S5) verbunden ist, zum Empfangen des L1-Signals und des L2-Signals, das vom Eingabe-Auswahlmittel ausgegeben wird und zum Auswählen, ob entweder ein Gleichtaktmodus oder ein Differentialbetrieb festzulegen ist,
wobei das CM/DM-Auswahlmodul (36) enthält:
einen Leitungsumwandler (40) zum Empfangen des eingegangenen L1-Signals und zum Übertragen einer von diesem ausgegebenen Ausgabe an das Ausgabe-Auswahlmittel;
einen Modusauswahl-Schalterkasten (42) zum Empfangen des eingegangenen L2-Signals, wobei der Modusauswahl-Schalterkasten einen Schalter aufweist, um entweder den Gleichtaktmodus oder den Differentialbetrieb zu bestimmen; und
einen Auswahlumwandler (44) zum Auswählen des Gleichtaktmodus oder des Differentialbetriebs durch Umschalten von zwei zugehörigen Anschlussstellen basierend auf der Schalterauswahl des Modusauswahl-Schalterkastens (42), wobei ein Spulenkern und eine sekundäre Windung davon mit jenen des Leitungsumwandlers geteilt werden.

2. Vorrichtung nach Anspruch 1, weiters mit einer Stromversorgung (32) zur Spannungsversorgung des Auswahl-Schaltmittels, des Eingabemodus-Auswahlmittels, des Ausgabe-Auswahlmittels und des Steuermittels.

3. Vorrichtung nach Anspruch 1 oder 2, wobei das Ausgabe-Auswahlmittel mit einem elektromagnetischen Störungsempfänger (14) zum Analysieren des von diesem ausgegebenen Signals verbunden ist.

4. Vorrichtung nach Anspruch 1, 2 oder 3, weiters mit einem Fehlerbeseitigungsmodul (22) mit einem Standardfilter zum Dämpfen der Signale von der Ll- und L2-Leitung durch Verwenden des Standardfilters, wenn ein Prüfling eingesetzt wird, um einen Rauschmessplan zu entwerfen.

## Revendications

1. Appareil pour analyser une interférence électromagnétique en divisant un bruit conducteur généré à partir d'un équipement à tester (EUT) en quatre modes à mesurer, dans lequel les quatre modes comprennent un mode L1 pour mesurer un bruit à partir d'une ligne L1 de lignes électriques, un mode L2 pour mesurer un bruit de l'autre ligne L2 des lignes électriques, un mode commun pour mesurer un bruit entre la ligne L1 et/ou la ligne L2 et une terre et un mode différentiel pour mesurer un bruit entre la ligne L1 et la ligne L2, l'appareil comprenant un moyen de commutation de sélection (25) pour sélectionner un mode parmi les quatre modes sur la base de la sélection d'un utilisateur pour générer un signal de sélection, un moyen de sélection de mode d'entrée pour actionner une pluralité de commutateurs employés à l'intérieur de celui-ci pour être commutés en tant que mode sélectionné sur la base du signal de sélection, un moyen de sélection de sortie (34) pour sélectionner l'une des sorties du moyen de sélection de mode d'entrée ; et un moyen de commande pour commander le moyen de sélection de mode d'entrée et le moyen de sélection de mode de sortie sur la base du signal de sélection,
dans lequel le moyen de sélection de mode d'entrée comprend:
un commutateur (S2) pour commuter le signal L1 entré sur la base du signal de sélection ;
un commutateur (S5) pour commuter le signal L2 entré sur la base du signal de sélection ; et
un commutateur (S3), connecté au commutateur (S2), pour sélectionner le mode L1 en déterminant si le signal L1 délivré du moyen de sélection d'entrée doit être connecté au moyen de sélection de sortie ou à une impédance de borne connectée à une terre, un commutateur (S6) connecté au commutateur (S5), pour sélectionner le mode L2 en déterminant si le signal L2 délivré du moyen de sélection d'entrée est connecté au moyen de sélection de sortie ou à une impédance de borne connectée à la terre, et un module de sélection de mode commun/mode différentiel (ci-après désigné en tant que « CM/DM ») (36) connecté à chacun du commutateur (S2) et du commutateur (S5), pour recevoir le signal L1 et le signal L1 délivré du moyen de sélection d'entrée et sélectionner si un mode commun ou un mode différentiel doit être déterminé,
dans lequel le module de sélection CM/DM (36) continent :
un transformateur de ligne (40) pour recevoir le signal L1 en tant qu'entrée de celui-ci et transmettre une sortie de celui-ci au moyen de sélection de sortie ;
un boîtier de commutation de sélection de mode (42) pour recevoir le L2 en tant qu'entrée de celui-ci, dans lequel le boîtier de commutation de sélection de mode a un commutateur pour déterminer le mode commun ou le mode différentiel ; et
un transformateur de sélection (44) pour sélectionner le mode commun ou le mode différentiel en commutant sur deux bornes de celui-ci sur la base de la sélection de commutation du boîtier de commutation de sélection de mode (42), dans lequel un noyau et un bobinage secondaire de celui-ci sont partagés avec ceux du transformateur de ligne.

2. Appareil selon la revendication 1, comprenant en outre une alimentation électrique (32) pour fournir une tension d'alimentation au moyen de commutation de sélection, au moyen de sélection de mode d'entrée, au moyen de sélection de sortie et au moyen de commande.

3. Appareil selon la revendication 1 ou 2, dans lequel le moyen de sélection de sortie est connecté à un récepteur d'interférence électromagnétique (14) pour analyser le signal délivré de celui-ci.

4. Appareil selon la revendication 1, 2 ou 3, comprenant en outre un module de débogage (22) qui a un filtre standard, pour amortir les signaux de L1 et L2 en utilisant le filtre standard lorsqu'un échantillon de test est utilisé pour établir un plan contre le bruit.
